# EUROPÄISCHE PATENTANMELDUNG

(11) **EP 0 747 955 A2**
(43) Veröffentlichungstag der Anmeldung: **11.12.1996**
(21) Anmeldenummer: 96105313.9
(22) Anmeldetag: 03.04.1996
(51) Int. Cl.: H01L 25/16, H01L 21/98

(54) **Hybridschaltung und Verfahren zur Herstellung derselben**

(30) Priorität: 07.06.1995 DE 19520676
(71) Anmelder: Deutsche Telekom AG, 53113 Bonn (DE)
(72) Erfinder: Nohr, Wolf-Dieter, Dipl.-Ing., 12621 Berlin (DE); Hanke, Gerhard, Dipl.-Ing., 64401 Gross-Bieberau (DE)

(57) **Zusammenfassung**

Für eine Hybridschaltung werden - zur höchstfrequenzgeeigneten Kontaktierung gehäuseloser Halbleiterschaltungen auf Substraten - in dem betreffenden Substrat Durchbrüche erzeugt, die dann mit einem mechanisch stabilen aber selektiv gut löslichen Füllmaterial bündig zur Substratoberfläche ausgefüllt werden. Anschließend werden die für die Kontaktierung der Halbleiterschaltung mit der Hybridschaltung notwendigen Leads im Bereich des Substratdurchbruchs erzeugt und das Füllmaterial herausgelöst. Die Kontaktierung der Halbleiterschaltung erfolgt in den Substratdurchbrüchen face-down mit den Leads.

Durch die genannten Maßnahmen ist es gelungen, eine für Höchstfrequenzen geeignete Hybridschaltung zu schaffen, die durch vergleichsweise geringen technologischen Aufwand realisierbar ist, ohne daß Beeinträchtigungen der Halbleiter-Chips (etwa durch hohe Belastung derselben) befürchtet werden müssen.

## Beschreibung

Die Erfindung bezieht sich auf eine Hybridschaltung nach dem Oberbegriff des Patentanspruchs 1 und auf ein Verfahren nach dem Oberbegriff des Patentanspruchs 4.

Es ist bekannt, daß der Einbau gehäuseloser Halbleiterschaltungen in Hybridschaltungen eine Vielzahl technisch/technologischer Vorteile bringt. Dabei werden die unterschiedlichsten Kontaktierungsverfahren angewendet. Die gängigsten Verfahren sind: das Chip-and-Wire-Verfahren, das Tape-Automated-Bonding-Verfahren (TAB), die Flip-Chip-Montage-Technik und das Beam-Lead-Bonding-Verfahren. Dazu gehören außerdem noch die verschiedenen Die-Bondverfahren, die hier außer Betracht gelassen werden. Die o. g. Kontaktierungsverfahren sind jedoch entweder nicht in der Lage, den außerordentlich hohen Ansprüchen einer Höchstfrequenzschaltung, die z. B. Bitraten von ≧ 20 Gbit/s verarbeiten soll, zu genügen oder bedingen eine spezielle Halbleiterausführung oder -behandlung, die z. T. technologisch sehr aufwendig ist.

Beim Chip-and-Wire-Verfahren treten z. B. zusätzliche Induktivitäten auf, die bei der Schaltungsentwicklung beachtet werden müssen. Der nichtangepaßte Übergang: Halbleiter(-Pads) - Drahtbrücke - Schaltkreisstruktur führt zum Entstehen elektrischer Stoßstellen, was in unterschiedlicher Abstufung auch für die nachfolgend genannten Kontaktierungsmethoden zutrifft. Bessere Höchstfrequenzeigenschaften besitzen die anderen genannten Kontaktierungsmethoden.

So sind durch Flip-Chip-Montage deutlich bessere Höchstfrequenzübertragungsergebnisse erzielbar. Jedoch stellt neben dem Auftreten zusätzlicher Kapazitäten auch die Wärmeableitung vom Halbleiterchip ein Problem dar. Der Aufbau spezieller Bumps ist nötig.

Das TAB ist maschinell aufwendig und bedingt eine spezielle Bumping-Technologie.

Gute Höchstfrequenz-Übertragungsergebnisse sind durch Beam-Lead-Montage zu erreichen. Diese bedingt jedoch eine spezielle Bauelementeausführung.

Da es insbesondere auch durch eine Oberflächenmontage der Halbleiterschaltungen zur Ausbildung zusätzlicher elektrischer Stoßstellen kommt, ist es verbreitet üblich, die Halbleiterschaltung in das Substrat einzusenken, um somit bessere Höchstfrequenzeigenschaften zu erzielen. Bekannt sind dazu in weiterentwickelter Form des weiteren die Chipeinbettungstechniken, bei denen die Halbleiterchips in Substratvertiefungen oder Substratdurchbrüchen so angebracht werden, daß z. B. die Oberflächen der Hybridschaltung und des Halbleiterchips bündig sind und anschließend der Spalt zwischen Halbleiterchip und Substrat isolierend ausgefüllt bzw. überbrückt wird. Danach werden schichttechnisch die strukturierten Anschlußmetallisierungen hergestellt. Eine Lösung für die Montage von Halbleiterchips in Schichtdurchbrüchen wird z. B. in der VTE 3/92, S. 112-116, beschrieben. Dabei werden die Chips durch Anwendung einer Hilfsfolie fixiert, die nach dem Befestigen des Chips mit einem Kunststoff wieder entfernt wird. Die Kontaktierungsstrukturierung wird anschließend vorgenommen. In der DE 3925604 und der EP 0516170 werden Lösungen zur Halbleitermontage in Substratvertiefungen beschrieben. Die bekannten Chipeinbettungsverfahren haben den Mangel, daß das Aufbringen (und Strukturieren) der Kontaktierungsschichten für die Verbindung: Chip-Hybridschaltkreis nach der Halbleitermontage erfolgt. Dadurch können (zu) hohe Belastungen für den Halbleiterchip entstehen. Die bekannten Methoden der Chipeinbettung sind technologisch aufwendig; insbesondere eine hochgenaue, bündige Montage in Substratvertiefungen ist schwierig. Eine an sich vorteilhafte schichttechnische Halbleiterkontaktierung ist nur durch ein Ausfüllen oder Überbrücken des Spaltes zwischen Halbleiterchip und Hybridschaltkreis möglich. Die Erstellung von Multi-Chipanordnungen ist wegen der schwierigen Justage der Hybridschaltungsstruktur (bzw. Leads) zu den vorher fixierten, mit jeweils individuellen Plazierungstoleranzen behafteten, Halbleiterchips problematisch.

Ausgehend von dem geschilderten Stand der Technik besteht die Aufgabe der Erfindung darin, eine für Höchstfrequenzen geeignete Hybridschaltung der eingangs bezeichneten Art zu schaffen, die durch vergleichsweise geringen technologischen Aufwand realisierbar ist, ohne daß Beeinträchtigungen der Halbleiter-Chips (etwa durch hohe Belastung derselben) befürchtet werden müssen.

Gemäß der Erfindung wird die Aufgabe durch die im Patentanspruch 1 angegebenen Merkmale und - was das Herstellungsverfahren betrifft - durch die aus Patentanspruch 4 entnehmbaren Maßnahmen gelöst.

Die mit der Erfindung erzielten Vorteile bestehen insbesondere darin, daß anknüpfend an die höchstfrequenzgünstigen Chipeinbettungstechniken, im ersten Schritt die Hybridschaltungs-Halbleiterschaltungs-Anschlußstege (Leads), z. B. gemeinsam mit der Hybridschaltungsstruktur, auf dem Substrat erzeugt werden können und dann die Justage, Fixierung und Kontaktierung der Halbleiterschaltung mit der Hybridschaltung im schon vorher vorbereiteten Substratdurchbruch der Hybridschaltung quasi in einem komplexen technologisch unaufwendigen Schritt erfolgt. Eine nachträgliche Belastung der Halbleiterchips tritt nicht auf. Ein weiterer Vorteil ist, daß spezielle Bumping-Technologien nicht nötig sind.

Technologisch vorteilhaft ist, daß für die Halbleitermontage durchgehende Substratöffnungen verwendet werden und auch keine Fixierhilfen in Z-Richtung nötig sind. Die Paßgenauigkeit des Substratdurchbruches kann relativ großzügig gehalten sein. Das heißt, daß die Durchbrüche in die für höchste Bitratenübertragung notwendigen keramischen Substratmaterialien, z. B. mittels einfacher Laserschneidtechnik, erzeugt werden können.

Dadurch, daß die einzelnen Halbleiterchips zu der vorher erstellten Hybridschaltungsstruktur (bzw. Leads) jeweils individuell justiert werden können, ist die Erfindung auch vorteilhaft für die Herstellung von Multichipanordnungen anwendbar.

Vorteilhafte Weiterbildungen des gegenständlichen Teils der Erfindung sind Patentanspruch 2 und 3 zu entnehmen.

Weiterbildende und vorteilhafte Ausgestaltungen des verfahrensmäßigen Teils der Erfindung enthalten die Patentansprüche 4 bis 21.

Die Erfindung ist nun anhand von Ausführungsbeispielen in der Zeichnung veranschaulicht und nachstehend näher erläutert. Es zeigt:
- Fig. 1: - jeweils im Vertikalschnitt in Durchbruchmitte, durch zwei spätere Leads (ausschnittsweise) und in starker Vergrößerung - den technologischen Ablauf (in 8 Phasen, beziffert I bis VIII) zur Herstellung der Leads zur Kontaktierung einer Halbleiterschaltung mit einem Hybridschaltkreis,
- Fig. 2: - in Schnittdarstellung entsprechend Fig. 1 - einen Ausschnit einer nach den aus Fig. 1 ersichtlichen Verfahrensschritten erstellten Hybridschaltung mit einem kontaktierten Halbleiterchip, und
- Fig. 3: - in Schnittdarstellung entsprechend Fig. 2 - eine gegenüber Fig. 1 abgewandelte (ergänzte) Ausführungsform einer Hybridschaltung.

Es bezeichnet 10 ein - vorzugsweise aus keramischem Material, z. B. Al₂O₃-Dünnschichtkeramik, bestehendes - Substrat, das auf einer - 11 - seiner beiden Oberflächen 11, 12 (strukturseitig) mit einer dünnen ersten Leitschicht 13 beschichtet ist. Diese kann - vorzugsweise - aus Cr(5nm)/Au(0,2 µm) bestehen und ist zweckmäßigerweise im Vakuumbeschichtungsverfahren auf die Substratoberfläche 11 aufgebracht (Phase I).

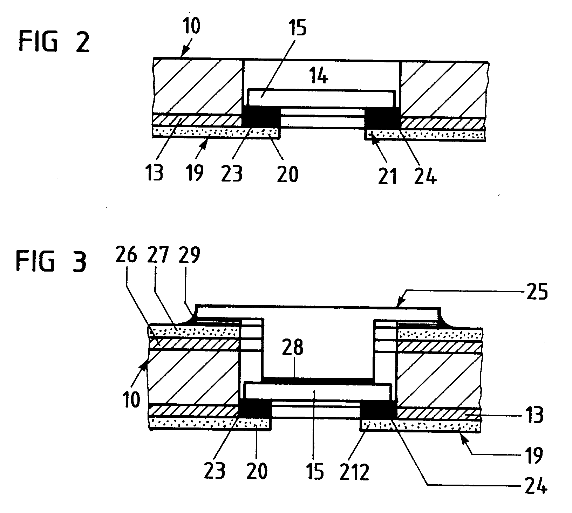

In Phase II wird in das Substrat, einschließlich erste Leitschicht 13, - vorzugsweise lasertechnologisch - ein Durchbruch 14 eingearbeitet, der etwas größer als eine (später einzusetzende) Halbleiterschaltung 15 (siehe Fig. 2 und 3) bemessen ist.

In Phase III wird der Substratdurchbruch 14 mit einem Füllmaterial 16, wofür sich z. B. Indium gut eignet, ausgefüllt. Das Einfüllen des Füllmaterials 16 kann auf mechanischem Wege, z. B. durch Eindrücken, geschehen. Leiterseitig überschüssiges, d. h. über die Außenfläche der ersten Leitschicht 13 überstehendes, Füllmaterial wird entfernt. Anschließend sollte die Probe, z. B. in einer Iso-Propanol-Dampfphase, gereinigt werden.

In Phase IV wird eine insgesamt mit 17 bezifferte Lackhaftmaske für die Hybridschaltkreisstruktur auf die erste Leitschicht 13 bzw. auf den geglätteten Abschluß des Füllmaterials 16 aufgebracht. Im gezeigten Ausführungsbeispiel (Phase IV) ist als Lackhaftmaske 17 eine Negativmaske verwendet worden, die dann zum Aufbau der Schaltkreisstruktur benutzt wird (Semi-additiv-Methode). Hierzu wurde aus einem zyanidischen Goldelektrolyten z. B. eine 10-µm dicke Goldschicht abgeschieden, die dann die eigentliche - zweite - Leitschicht 19 bildet. Die Lackhaftmaske 17 ist so geartet, daß sie einerseits im Bereich der Leitschicht 19 die Hybridschaltkreisstruktur (nicht gezeigt) und andererseits die Anschlußstege (sogenannte Leads) 20, 21 im Bereich des Substratdurchbruchs 14 - auf dem Füllmaterial 16 - ausbildet. Um die zweite (jetzt strukturierte) Leitschicht 19, insbesondere die von ihr gebildeten Leads 20, 21, zu stabilisieren, sowie als Abdeckung für nachfolgende galvanische Abscheidungen, sieht Phase V deren Beschichtung mit einer weiteren Lackschicht vor, die mit 22 bezeichnet ist.

Die sich daran anschließende Phase VI sieht die Herauslösung des Füllmaterials 16 aus dem Substratdurchbruch 14 vor. Wenn als Füllmaterial 16 Indium verwendet wurde, ist für die Herauslösung z. B. eine an sich bekannte Cer-Sulfat-Ätzlösung geeignet.

Danach werden - im Zuge der Phase VII - auf die Leads 20, 21 unterseitig Lothügel 23, 24 abgeschieden. Dieser Vorgang kann z. B. durch Abscheidung von Indium aus einem Sulfamatelektrolyten in einer Dicke von z. B. 2 µm erfolgen. (Es sind aber auch andersartige Lote denkbar.) Das Umwachsen des Indiums (der Lote 23, 24) seitlich um die Leads 20, 21 wird durch die noch vorhandene (Aufbau-)Lackhaftmaske 17 verhindert.

Ein eventuelles seitliches "Überwachsen" der Indium-Schicht kann durch einen abschließenden kurzen Anschmelzprozeß rückgängig gemacht werden.

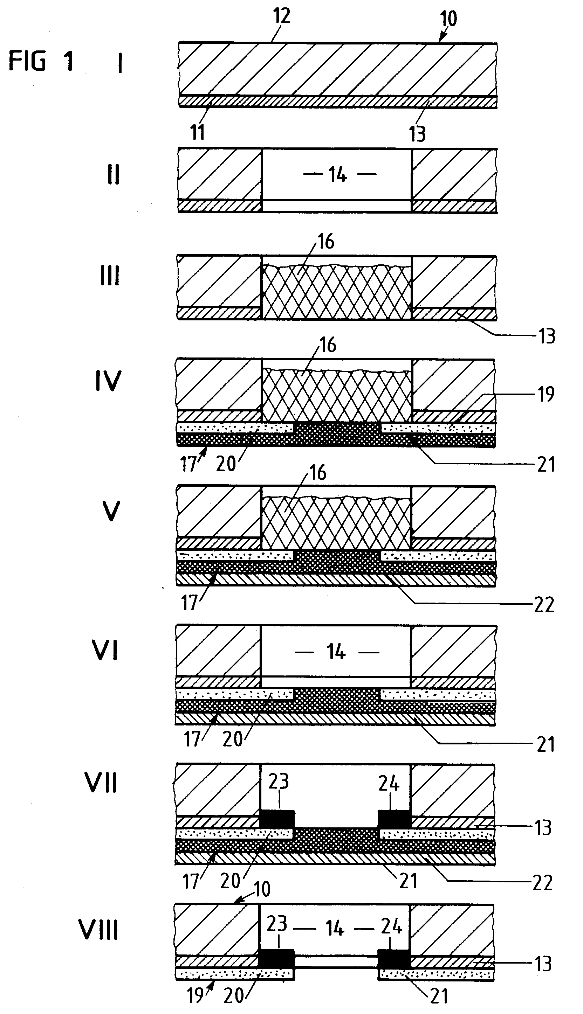

In einem darauffolgenden weiteren Verfahrensschritt (Phase VIII in Fig. 1) werden die Lackhaftmaske 17 und die Lackschicht 22 entfernt. Es liegt damit ein fertiger, mit kontaktierfähigen freistehenden Leads 20, 21 versehener Substratdurchbruch 14 vor, nachdem noch die die Hybridschaltkreisstruktur (nicht gezeigt) mit den Leads (20, 21) umgebende (Rest-)Leitschicht (13), z. B. durch Sputterätzen, entfernt wurde.

Der solcherart vorbereitete Substratdurchbruch 14 ist nun für Justage, Fixierung und Kontaktierung der Halbleiterschaltung 15 bereit, was anhand von Fig. 2 erläutert werden soll. Die Montage der Halbleiterschaltung 15 wird zweckmäßig face-down mit einem üblichen Face-down-Bauelemente-Placer (nicht gezeigt) vorgenommen.

Die lötfähigen Pads (nicht gezeigt) der Halbleiterschaltung 15 werden, vorzugsweise, durch Schmelzkontaktierung (Löten) mit den die Lothügel 23, 24 aufweisenden Leads 20, 21 verbunden. Die benötigte Schmelzwärme kann z. B. durch eine Heizplatte erzeugt werden, auf der das (Hybridschaltkreis-)Substrat 10 leiterseitig plaziert ist. Außer Löten sind aber auch noch andere gängige Verbindungstechnologien denkbar.

In Fig. 3 ist eine Ausführungsform gezeigt, die sich gegenüber Fig. 2 durch die Besonderheit der Anbringung eines Rückseitenelements auszeichnet, welches insgesamt mit 25 bezeichnet ist. Das im Querschnitt gezeigte (Hybridschaltkreis-)Substrat 10 weist hier eine Rückseitenmetallisierung 26, 27 auf, die in ihrem Aufbau z. B. der Stimme der beiden Leitschichten 13 und 19 entspricht.

Das Rückseitenelement 25 kann in Form eines Stempels o. ä. ausgeführt sein. Wie Fig. 3 weiterhin erkennen läßt, ist das Rückseitenelement 25 - bei 28 - einerseits mit der Halbleiterschaltung 15 und - bei 29 - andererseits mit der Rückseitenmetallisierung 26, 27 und damit mit dem Substrat 10 verbunden. Die Verbindungen - 28 bzw. 29 - können als Klebe- oder ggf. auch als Lötverbindungen ausgeführt sein. Daraus ergibt sich eine großzügige Gestaltung der Höhenanpassung des Rückseitenelements 25, da die (Klebe- bzw. Löt-)Verbindungen 28 bzw. 29 ausgleichend wirken.

Soll das Rückseitenelement 25 nur zur mechanischen Stabilisierung verwendet werden, so können für Rückseitenelement 25 und Verbindungen 28 bzw. 29 isolierende Materialien (z. B. Kleber) verwendet werden.

Falls indessen das Rückseitenelement 25 als Kühlelement verwendet werden soll, so müssen Rückseitenelement 25 und Verbindungen 28 bzw. 29 eine gute Wärmeleitfähigkeit besitzen. Die Wärme wird zur Rückseite des (Hybridschaltkreis-)Substrats 10 abgeleitet.

Es kann auch erforderlich sein, zusätzlich einen elektrischen Kontakt zwischen der Rückseite der Halbleiterschaltung 15 und der Rückseitenmetallisierung 26, 27 zu ermöglichen. In diesem Falle müssen Rückseitenelement 25 und Verbindungen 28 bzw. 29 die entsprechende elektrische Leitfähigkeit aufweisen. Die rückseitige Verbindung der Halbleiterschaltung 15 mit dem Substrat 10 - speziell mit der Substratrückseite 12 bzw. mit der auf ihr aufgebrachten Rückseitenmetallisierung 26, 27 - kann auch formlos durch Kleber, Lote u. ä. erfolgen.

## Patentansprüche

1. Hybridschaltung mit einer oder mehreren gehäuselosen Halbleiterschaltungen (15), die - zur höchstfrequenzgeeigneten Kontaktierung - jeweils im Durchbruch (14) eines Substrates (10), vorzugsweise bündig zur Substratoberfläche (11), die die eigentliche Hybridschaltungsstruktur, gebildet durch Leitschichten (13, 19), tragen soll, versenkt angeordnet sind, derart, daß eine elektrische Verbindung der Halbleiterschaltungen (15) zu (Hybridschaltungs-)Anschlußstegen (sogenannten Leads 20, 21) besteht,
dadurch gekennzeichnet, daß das auf das Substrat (10) aufgebrachte Leitschichtsystem (13, 19) frei in den Durchbruch (14) hineinragende Leads (20, 21) bildet, und daß die Halbleiterschaltung (15) mit den Innenflächen der Leads (20, 21) elektrisch verbunden ist.

2. Hybridschaltung nach Anspruch 1,
dadurch gekennzeichnet, daß die Leads (20, 21) Bestandteil der auf das Substrat (10), d. h. auf die Substratoberfläche (11), aufgebrachten Hybridschaltungsstruktur sind.

3. Hybridschaltung nach Anspruch 1 oder 2,
dadurch gekennzeichnet, daß die sich im Substratdurchbruch (14) befindende und kontaktierte Halbleiterschaltung (15) rückseitig durch ein stempelähnliches Rückseitenelement oder auch formlos durch Lote, Kleber oder dergleichen mit der Substratrückseite (12), die eine Rückseitenmetallisierung (26, 27) tragen kann, verbunden ist.

4. Verfahren zur Herstellung einer Hybridschaltung nach Anspruch 1, 2 oder 3,
dadurch gekennzeichnet, daß in einem Substrat (10) ein durchgehender Durchbruch (14) für eine einzubringende Halbleiterschaltung (15) erzeugt wird, daß anschließend der Durchbruch (14) mit einem mechanisch stabilen, jedoch selektiv gut löslichen Füllmaterial (16) so ausgefüllt wird, daß strukturseitig eine plane Substratoberfläche entsteht, daß anschließend neben oder mit der eigentlichen Hybridschaltkreisstruktur eine Anschlußstege (sogenannte Leads 20, 21) für die Halbleiterschaltung (15) bildende Leitschicht (19) aufgebracht und/oder gleichzeitig strukturiert wird, daß anschließend das Füllmaterial (16) aus dem Durchbruch (14) herausgelöst wird bis die Leads (20, 21) freiliegen, und daß schließlich die Justierung, Fixierung und Kontaktierung der Halbleiterschaltung (15) innerhalb des Substratdurchbruchs (14) erfolgt.

5. Verfahren nach Anspruch 4,
dadurch gekennzeichnet, daß eine erste Leitschicht (13) schon vor Erzeugung des Substratdurchbruchs (14) auf die strukturseitige Substratoberfläche (11) aufgetragen und anschließend in einem Arbeitsgang der Durchbruch (14) durch Substrat (10) und erste Leitschicht (13) vorgenommen wird (Phase II in Fig. 1).

6. Verfahren nach Anspruch 4,
dadurch gekennzeichnet, daß eine erste Leitschicht (13) erst nach Erzeugung des Substratdurchbruchs (14) und vor oder nach dessen Ausfüllung mit dem Füllmaterial (16) auf die strukturseitige Substratoberfläche (11) aufgetragen wird.

7. Verfahren nach Anspruch 5 oder 6,
dadurch gekennzeichnet, daß auch andere Leitschichtkombinationen vor oder nach dem Erzeugen des Durchbruchs (14) im Substrat (10) vorderseitig (11) oder/und rückseitig (12) zwecks späterer oder in schon vorhandener Struktur aufgetragen werden können.

8. Verfahren nach einem oder mehreren der Ansprüche 4 bis 7,
dadurch gekennzeichnet, daß nach dem Herauslösen des Füllmaterials (16) aus dem Substratdurchbruch (14) auf den freigelegten Innenseiten der Leads (20, 21) Lothügel (23, 24) erzeugt werden.

9. Verfahren nach einem oder mehreren der Ansprüche 4 bis 7,
dadurch gekennzeichnet, daß außer Lothügel (23, 24), die zur Kontaktierung dienen, auch andere Kontaktierhilfsschichten zur Ermöglichung weiterer Verbindungstechniken auf die Leads (20, 21) aufgetragen werden können.

10. Verfahren nach Anspruch 4,
dadurch gekennzeichnet, daß der Substratdurchbruch (14) mit einem weichen Metall, vorzugsweise Indium, ausgefüllt und anschließend der strukturseitig über das Substrat (10) überstehende Teil des Füllmaterials (16) entfernt wird (Phase III in Fig. 1).

11. Verfahren nach Anspruch 10,
dadurch gekennzeichnet, daß eine Lackhaftmaske (17), vorzugsweise eine Negativmaske, verwendet wird, die dann zum Aufbau der Leads (20, 21), bestehend aus der Leitschicht (19), benutzt wird (sogenannte Semi-additiv-Methode).

12. Verfahren nach einem oder mehreren der Ansprüche 4 bis 11,
dadurch gekennzeichnet, daß die Leads (20, 21) in einem Arbeitsgang mit der übrigen Hybridschaltkreisstruktur strukturiert bzw. aufgebaut werden.

13. Verfahren nach Anspruch 11 oder 12,
dadurch gekennzeichnet, daß die in der Lackhaftmaske (17) aufzubauenden Leads (20, 21) durch galvanisches Abscheiden einer Leitschicht erzeugt werden.

14. Verfahren nach Anspruch 11, 12 oder 13,
dadurch gekennzeichnet, daß zur Stabilisierung der Leads (20, 21) sowie als Abdeckung für nachfolgende galvanische Abscheidungen vor dem Herauslösen des Füllmaterials (16) aus dem Substratdurchbruch (14) auf die strukturierte Leitschicht (19), welche die Leads (20, 21) beinhaltet, eine weitere Lackschicht (22) aufgetragen wird (Phase V in Fig. 1).

15. Verfahren nach Anspruch 4,
dadurch gekennzeichnet, daß nach dem Herauslösen des Füllmaterials (16), vorzugsweise durch Verwendung einer an sich bekannten Cer-Sulfat-Lösung (Phase VI in Fig. 1), auf die nun freiliegenden Leads (20, 21) - z. B. galvanisch - ein Lot (23, 24) abgeschieden wird (Phase VII in Fig. 1) und daß anschließend die Lackhaftmaske (17) und die stabilisierende Lackschicht (22) entfernt werden (Phase VIII in Fig. 1), daß dann ggf. die Rest-Leitschicht (13), z. B. durch Sputterätzen, entfernt wird und daß anschließend die Justage der Halbleiterschaltung (15) in dem Substratdurchbruch (14) und schließlich ihre Fixierung und Kontaktierung bezüglich der Leads (20, 21), vorzugsweise durch Herstellen einer Lötverbindung mit den Lothügeln (23, 24), erfolgt (Fig. 2).

16. Verfahren nach Anspruch 15,
dadurch gekennzeichnet, daß die Montage der Halbleiterschaltung (15) in dem Substratdurchbruch (14) face-down mittels eines Face-down-Bauelemente-Placers vorgenommen wird.

17. Verfahren nach einem oder mehreren der Ansprüche 4 bis 16,
dadurch gekennzeichnet, daß auf der von der Strukturseite (11) abgewandten Rückseite (12) des Substrats (10) ein weiteres Leitschichtsystem (Rückseitenmetallisierung 26, 27) aufgebracht wird und daß - vor oder nach der Halbleiterkontaktierung - ein Rückseitenelement (25) auf der Rückseite der Halbleiterschaltung (15) befestigt wird, welches anschließend mit der Rückseitenmetallisierung (26, 27) verbunden werden kann (Fig. 3).

18. Verfahren nach Anspruch 17,
dadurch gekennzeichnet, daß das Rückseitenelement (25) zur mechanischen Stabilisierung dient und - vorzugsweise durch Kleben - einerseits mit der Halbleiterschaltung (15) (bei 28), andererseits mit der Rückseitenmetallisierung (26, 27) (bei 29) verbunden wird.

19. Verfahren nach Anspruch 17,
dadurch gekennzeichnet, daß das Rückseitenelement (25) als Kühlelement dient und wärmeleitend durch Kleben oder Löten einerseits mit der Halbleiterschaltung (15) (bei 28), andererseits mit der Rückseitenmetallisierung (26, 27) (bei 29 ) verbunden wird.

20. Verfahren nach Anspruch 17 und/oder 19,
dadurch gekennzeichnet, daß das Rückseitenelement(25) elektrisch leitend durch Kleben oder Löten einerseits mit der Halbleiterschaltung (15) (bei 28), andererseits mit der Rückseitenmetallisierung (26, 27) (bei 29) verbunden wird.

21. Verfahren nach einem oder mehreren der Ansprüche 4 bis 20,
dadurch gekennzeichnet, daß die rückseitige Verbindung der Halbleiterschaltung (15) mit dem Substrat (10) - speziell mit der Substratrückseite (12), bzw. mit der auf ihr aufgebrachten Rückseitenmetallisierung (26, 27) - auch formlos durch Kleber, Lote und ähnliches erfolgen kann.
